# EUROPÄISCHE PATENTSCHRIFT

(11) **EP 3 262 627 B1**
(45) Veröffentlichungstag und Bekanntmachung des Hinweises auf die Patenterteilung: **12.05.2021**
(21) Anmeldenummer: 16706170.4
(22) Anmeldetag: 23.02.2016
(51) Int. Cl.: G09F 9/33, G09F 13/04, H05K 1/14, H01L 33/48, G09F 9/302

(54) **LEUCHTDIODENVORRICHTUNG UND VERFAHREN ZUM HERSTELLEN EINER LEUCHTDIODENVORRICHTUNG**
LIGHT-EMITTING DIODE APPARATUS AND METHOD FOR MANUFACTURING A LIGHT-EMITTING DIODE APPARATUS
DISPOSITIF À DIODE ÉLECTROLUMINESCENTE ET PROCÉDÉ DE FABRICATION D'UN DISPOSITIF À DIODE ÉLECTROLUMINESCENTE

(30) Priorität: 23.02.2015 DE 102015002099
(43) Veröffentlichungstag der Anmeldung: 03.01.2018
(73) Patentinhaber: JENOPTIK Optical Systems GmbH, 07745 Jena (DE)
(72) Erfinder: KLOTH, Bernd, 16547 Birkenwerder (DE); FLÜGEL, Matthias, 10247 Berlin (DE); JAIKOW, Roman, 12619 Berlin (DE)
(74) Vertreter: Waldauf, Alexander
(86) Internationale Anmeldenummer: PCT/EP2016/053701
(87) Internationale Veröffentlichungsnummer: WO 2016/135110

(56) Entgegenhaltungen:
- EP-A1- 1 696 404
- DE-U1-202011 050 596
- US-A- 4 058 919
- US-A1- 2002 175 421
- US-A1- 2007 285 917
- US-A1- 2008 142 961
- US-B1- 6 252 350

## Beschreibung

### Stand der Technik

Die vorliegende Erfindung bezieht sich auf eine Leuchtdiodenvorrichtung und ein Verfahren zum Herstellen einer Leuchtdiodenvorrichtung.

LED-Chips werden entweder in diskrete Gehäuse mit transparenten Fenstern oder Linsen verkapselt oder gemeinsam mit anderen Chips auf eine Trägerleiterplatte z. B. aus glasfaserverstärktem Epoxidharz oder Keramik montiert. Zur elektrischen Kontaktierung werden die einzelnen Chips dabei auf der Unterseite elektrisch leitend geklebt oder gelötet und auf der Oberseite mit Aluminium- oder Golddraht gebondet.
Eine Leiterplatte ist das am häufigsten eingesetzte Verbindungselement für elektronische Bauteile. Sie ist gekennzeichnet durch elektrisch leitende, festhaftende Verbindungen in oder auf einem Isolierstoff und dient zusätzlich als Bauteilträger. Es können Informationen für Montage, Prüfung und Service aufgedruckt sein. Technische Anforderungen und die Wirtschaftlichkeit bestimmen die verschiedenen Ausführungen der Leiterplatte. Diese Leiterplatte im Sinne der vorliegenden Erfindung kann auch unterschiedliche Isolierstoffe, Laminate und Materialien aufweisen. Klassifizierungen und Klassen von Leiterplatten können sich nach Wärmeleitfähigkeit und Wärmedurchgangskoeffizienten unterscheiden. Unterschieden wird zudem nach der Klassifizierung nach Grundmaterial, elektronischer Leiterplatte beziehungsweise nach Endprodukt. Die genannten Beispiele erheben keinen Anspruch auf Vollständigkeit und sind somit auch nicht erschöpfend im Umfang des Schutzrechtsanspruchs.

So werden zum Beispiel durch die Anordnung von mehreren Display-LED-Chips auf einer Leiterplatte (z. B. PCB oder Keramik) ein- oder mehrzeilige Display-Arrays erzeugt. Eine weitere Möglichkeit zur Erzeugung von LED-Chip-Arrays besteht in der monolithischen Anordnung von mehreren z. B. 7-Segment-Digits auf einem Chip.
Die EP 103255 A2 beschreibt eine mehrstellige, elektrische Ziffernanzeigeeinrichtung für die Anzeige von Mengen- und Preisangaben in Treibstoffzapfstellen. Es sind elektromagnetisch ansteuerbare Klappenanzeigebausteine vorgesehen, die gemeinsam mit allen Bauelementen der elektronischen Steuerschaltung auf einer Leiterplatte angeordnet sind, die in eine einfache wannenförmige Form einsetzbar ist, welche mit einem fließenden, nachhärtbaren Gießharz zu einem gasdichten Block ausgießbar ist.

In EP 1696404 A1 wird eine an einer Leiterplatte befestigte SMD LED offenbart, deren Licht durch eine Öffnung in der Leiterplatte nach unten abgegeben wird. Aus US2007/0285917A1 ist eine Anzeige bekannt, die mehrere optische Pfade in einem Substrat enthält. Aus dieser Veröffentlichung ist bekannt, Leuchtdiodenelemente auf einer Leiterplatte zu befestigen, wobei deren Licht durch Öffnungen in der Leiterplatte mittels Totalreflexion geleitet wird. Die Emissionsbereiche der Leuchtdioden sind gegenüber der jeweiligen Durchgangsöffnung angebracht. Aus DE 202011050596 U1 ist ein LED Beleuchtungsmodul mit einer an einer Öffnung in einer Platine angebrachten Leuchtdiode bekannt. Der Emissionsbereich der Leuchtdiode ist gegenüber der Durchgangsöffnung angebracht. Rückseitig ist ein Kühlkörper vorgesehen. Aus US 2008/142961 A1 ist ein Keramik-Gehäusesubstrat mit einer Ausnehmung bekannt, in der ein Chip angeordnet ist. Dabei handelt es sich um ein Kondensatorarray oder eine Schaltung zur Spannungsregelung. Auf der Außenseite des Gehäusesubstrats ist ein funktionaler elektronischer Chip, beispielsweise ein Mikroprozessor, angeordnet. Aus US 2002/175421 A1 ist ein Multichipmodul mit einem oder mehreren Zwischensubstraten bekannt. Aus dieser Veröffentlichung ist bekannt, einen Hohlraum für eine elektronische Schaltung aus mehreren Lagen einer Leiterplatte zu bilden. Auf einem Silizium-Zwischensubstrat werden elektronische Chips befestigt. Das Zwischensubstrat wird so angeordnet und mit der Leiterplatte verbunden, dass die Chips in dem Hohlraum sind. Außerdem ist bekannt, ein Loch in der Leiterplatte vorzusehen, durch welches eine Vergussmasse in den Hohlraums eingefüllt werden kann. Aus US 6252350 B1 ist ein Lampengehäuse mit einer installierten SMD - LED bekannt. Diese kann auch mit einer nicht SMD LED kombiniert werden. Aus US 4058919 A ist eine Segmentanzeige mit mehreren flachen Einsätzen bekannt, wobei ein Einsatz wiederum in mehrere Sub-Einsätze mit dreieckigem Querschnitt unterteilt ist und in jedem Untereinsatz eine Lichtquelle angeordnet ist.

### Offenbarung der Erfindung

Vor diesem Hintergrund werden mit der vorliegenden Erfindung eine Leuchtdiodenvorrichtung und ein Verfahren zum Herstellen einer Leuchtdiodenvorrichtung gemäß den Hauptansprüchen vorgestellt. Vorteilhafte Ausgestaltungen ergeben sich aus den jeweiligen Unteransprüchen und der nachfolgenden Beschreibung.

Eine elektrische Kontaktierung eines Leuchtdiodenelements mit der Emissionsseite nach unten auf einer Leiterplatte mit einer Öffnung für eine freie Sicht auf den Emissionsbereich ermöglicht eine Realisierung einer miniaturisierten und kostengünstigen Leuchtdiodenvorrichtung.

Mit dem hier vorgestellten Konzept ist im Gegensatz zum bisher üblichen Chip- und Drahtbonden bei der Herstellung der Leuchtdiodenvorrichtung nur ein Montageschritt erforderlich. Die hierin vorgestellte LED-Chip-Anordnung kann insbesondere ohne empfindliche Bondrähte, die meist noch durch einen zusätzlichen Verguss oder eine Blendenkappe geschützt werden müssen, realisiert werden. Weiterhin können die mit der Oberseite nach unten gelöteten LED-Chips zwischen zwei Leiterplatten eingebettet werden und dadurch sehr robust gegen mechanische Einwirkungen gestaltet werden. Darüber hinaus kann der laterale Bauraum durch das Fehlen der Drahtbonds verringert und dadurch eine höhere Chipdichte sowohl in der x - als auch in y - Achse erreicht werden.

Die vorgeschlagenen Leuchtdiodenelemente können z. B. als LED-Anzeige-Chips eingesetzt werden, wobei als Folge der hier vorgeschlagenen Anordnung bei deren Betrachtung durch die Öffnung in der Trägerleiterplatte keine störenden Reflexe von Bonddrähten oder Leiterbahnstrukturen auftreten. Insbesondere können ein- oder mehrzeilige LED-Anzeige-Chipanordnungen bei der vorgeschlagenen Form der Montage und beim Einsatz von vertikalen Durchkontaktierungen in mehrlagigen Leiterplatten besonders dicht montiert werden, was eine höhere Informationsdichte als bisher bei der Einspiegelung von LED-Anzeige-Arrays in optische Strahlengänge ermöglicht.

Eine Leuchtdiodenvorrichtung weist die folgenden Merkmale auf:
ein Leuchtdiodenelement mit einer Vorderseite und einer Rückseite, wobei die Vorderseite einen Emissionsbereich zum Emittieren elektromagnetischer Wellen und einen dem Emissionsbereich zugeordneten Diodenanschlusskontakt aufweist; und
eine Leiterplatte mit einer Durchgangsöffnung und einem Plattenanschlusskontakt, wobei die Vorderseite des Leuchtdiodenelements mit der Leiterplatte verbunden ist, und
wobei der Emissionsbereich gegenüber der Durchgangsöffnung angeordnet ist und der Diodenanschlusskontakt gegenüber dem Plattenanschlusskontakt angeordnet ist und elektrisch leitend mit dem Plattenanschlusskontakt verbunden ist.

Bei dem Leuchtdiodenelement kann es sich um einen LED-Chip oder einen Teil eines LED-Chips handeln. Der Emissionsbereich kann ausgebildet sein, um ansprechend auf einen elektrischen Stromfluss durch das Leuchtdiodenelement Licht im sichtbaren Bereich oder im UV-Bereich auszugeben. Bei dem Diodenanschlusskontakt kann es sich um die Kathode oder die Anode des Leuchtdiodenelements handeln. Der Diodenanschlusskontakt kann benachbart zu dem Emissionsbereich angeordnet sein. Der Plattenanschlusskontakt der Leiterplatte kann ausgebildet sein, um den Diodenanschlusskontakt mit elektrischer Spannung zu versorgen.

Gemäß einer Ausführungsform der Leuchtdiodenvorrichtung kann die Vorderseite des Leuchtdiodenelements einen weiteren Emissionsbereich zum Emittieren weiterer elektromagnetischer Wellen und einen dem weiteren Emissionsbereich zugeordneten weiteren Diodenanschlusskontakt aufweisen. Entsprechend kann die Leiterplatte einen weiteren Plattenanschlusskontakt aufweisen. Dabei kann der weitere Emissionsbereich gegenüber der Durchgangsöffnung angeordnet sein und der weitere Diodenanschlusskontakt gegenüber dem weiteren Plattenanschlusskontakt angeordnet sein und elektrisch leitend mit dem weiteren Plattenanschlusskontakt verbunden sein. Damit kann die Leuchtdiodenvorrichtung vorteilhafterweise als Anzeige-LED zum Anzeigen einer Text- und/oder Zahleninformation eingesetzt werden.

Erfindungsgemäß weist die Leuchtdiodenvorrichtung eine Abdeckeinheit auf. Die Abdeckeinheit verfügt über eine Ausnehmung zum Aufnehmen des Leuchtdiodenelements und kann mit der Leiterplatte verbunden sein. Das Leuchtdiodenelement kann dabei in der Ausnehmung angeordnet sein. Die Abdeckeinheit mit der Ausnehmung kann zum Schutz und/oder zur elektrischen Kontaktierung des Leuchtdiodenelements dienen.

Insbesondere kann eine Tiefe der Ausnehmung eine Dicke des Leuchtdiodenelements übersteigen. So kann bei der fertigen Leuchtdiodenvorrichtung das Leuchtdiodenelement gegenüber einer Außenseitenoberfläche der Leuchtdiodenvorrichtung zurückstehen und besser vor etwaigen Beschädigungen im Gebrauch der Leuchtdiodenvorrichtung geschützt werden.

Die Abdeckeinheit setzt sich erfindungsgemäß aus einer weiteren Leiterplatte und einem an der weiteren Leiterplatte anliegenden Rahmenelement zusammen. Dabei ist die Ausnehmung durch eine Durchtrittsöffnung in dem Rahmenelement gebildet. Vorteilhaft kann die Abdeckeinheit schnell, kostengünstig und unter Verwendung von Standardbauteilen hergestellt werden. Darüber hinaus können mittels der weiteren Leiterplatte zusätzliche Funktionalitäten in die Leuchtdiodenvorrichtung integriert werden.

Erfindungsgemäß weist die Rückseite des Leuchtdiodenelements einen zweiten Diodenanschlusskontakt auf. Entsprechend kann die Leiterplatte einen zweiten Plattenanschlusskontakt aufweisen. Die Abdeckeinheit weist erfindungsgemäß einen Abdeckeinheitskontakt auf. Außerdem kann die Abdeckeinheit einen weiteren Abdeckeinheitskontakt und eine die Abdeckeinheitskontakte elektrisch leitfähig verbindende elektrische Leitung aufweisen. Der Abdeckeinheitskontakt ist erfindungsgemäß gegenüber dem zweiten Diodenanschlusskontakt angeordnet und elektrisch leitend mit dem zweiten Diodenanschlusskontakt verbunden. Der weitere Abdeckeinheitskontakt kann gegenüber dem zweiten Plattenanschlusskontakt angeordnet sein und elektrisch leitend mit dem zweiten Plattenanschlusskontakt verbunden sein. Diese Ausführungsform ermöglicht eine Rückseitenkontaktierung des Leuchtdiodenelements, wofür sich vorteilhafterweise kostengünstige Standartdiodenelemente einsetzen lassen. Zudem bietet diese Form der Kontaktierung einen besseren Schutz für die zweite Diode des verwendeten Leuchtdiodenelements.

Die Vorderseite des Leuchtdiodenelements kann einen dem Emissionsbereich zugeordneten zweiten Diodenanschlusskontakt aufweisen. Die Leiterplatte kann einen zweiten Plattenanschlusskontakt aufweisen, und der zweite Diodenanschlusskontakt kann gegenüber dem zweiten Plattenanschlusskontakt angeordnet sein und elektrisch leitend mit dem zweiten Plattenanschlusskontakt verbunden sein. Diese Form des elektrischen Anschlusses des Leuchtdiodenelements ermöglicht eine schnelle und kostengünstige Fertigung der Leuchtdiodenvorrichtung.

Die Leuchtdiodenvorrichtung kann mit zumindest einem zusätzlichen Leuchtdiodenelement ausgestattet sein. Entsprechend kann die Leiterplatte zumindest eine zusätzliche Durchgangsöffnung und zumindest einen zusätzlichen Plattenanschlusskontakt aufweisen. Ein zusätzlicher Emissionsbereich des zusätzlichen Leuchtdiodenelements kann gegenüber der zusätzlichen Durchgangsöffnung angeordnet sein und ein zusätzlicher Diodenanschlusskontakt des zusätzlichen Leuchtdiodenelements gegenüber dem zusätzlichen Plattenanschlusskontakt angeordnet sein und elektrisch leitend mit dem zusätzlichen Plattenanschlusskontakt verbunden sein. In dieser Ausführungsform kann die Leuchtdiodenvorrichtung ohne Weiteres zum Anzeigen komplexerer Informationen wie beispielsweise Text oder Zahlen eingesetzt werden.

Auch kann die Leuchtdiodenvorrichtung eine Treiberschaltung zum Ansteuern des Leuchtdiodenelements und zumindest einen Treiberkontakt zum elektrischen Kontaktieren der Treiberschaltung aufweisen. Die Treiberschaltung und der Treiberkontakt können an der Leiterplatte angeordnet sein. Damit kann das Leuchtdiodenelement vorteilhafterweise lokal mit kurzen Signalwegen angesteuert werden. Auch möglich ist es, mehrere Treiberschaltungen vorzusehen.

Die Treiberschaltung kann vorteilhaft auf der Rückseite der Leiterplatte angeordnet sein. Ebenfalls vorteilhaft kann die Treiberschaltung auf der weiteren Leiterplatte angeordnet sein, besonders vorteilhaft auf deren Rückseite, d.h. der Seite, die dem Leuchtdiodenelement gegenüberliegt. Die weitere Leiterplatte kann eine Mehrzahl von Treiberkontakten zum elektrischen Kontaktieren der Treiberschaltung aufweisen. Das Rahmenelement und/oder die weitere Leiterplatte können vorteilhaft Durchkontaktierungen und/oder Leiterbahnen aufweisen.

Ein Verfahren zum Herstellen einer Leuchtdiodenvorrichtung ist im Anspruch 10 definiert und weist unter anderem die folgenden Schritte auf:
Bereitstellen eines Leuchtdiodenelements mit einer Vorderseite und einer Rückseite, wobei die Vorderseite einen Emissionsbereich zum Emittieren elektromagnetischer Wellen und einen dem Emissionsbereich zugeordneten Diodenanschlusskontakt aufweist;
Bereitstellen einer Leiterplatte mit einer Durchgangsöffnung und einem Plattenanschlusskontakt; und

Fügen des Leuchtdiodenelements mit der Leiterplatte, wobei die Vorderseite des Leuchtdiodenelements mit der Leiterplatte verbunden wird, und wobei der Emissionsbereich gegenüber der Durchgangsöffnung angeordnet wird und der Diodenanschlusskontakt gegenüber dem Plattenanschlusskontakt angeordnet wird und elektrisch leitend mit dem Plattenanschlusskontakt verbunden wird.

Die Schritte einer Variante des hier vorgestellten Verfahrens können in entsprechenden Einrichtungen einer Fertigungsanlage voll- oder teilautomatisiert ausgeführt werden. Auch durch diese Ausführungsvariante der Erfindung in Form eines Verfahrens kann die der Erfindung zugrunde liegende Aufgabe schnell und effizient gelöst werden.

Die Erfindung wird nachstehend anhand der beigefügten Zeichnungen beispielhaft näher erläutert. Es zeigen:
Fig. 1 eine schematische Darstellung einer Leuchtdiodenvorrichtung gemäß einem Ausführungsbeispiel der vorliegenden Erfindung;
Fig. 2 eine Draufsicht auf eine Leuchtdiodenvorrichtung gemäß einem weiteren Ausführungsbeispiel der vorliegenden Erfindung;
Fig. 3 eine Schnittdarstellung der Leuchtdiodenvorrichtung aus Fig. 2, gemäß einem weiteren Ausführungsbeispiel der vorliegenden Erfindung;
Fig. 4 einen Detailausschnitt der Leuchtdiodenvorrichtung aus Fig. 3, gemäß einem Ausführungsbeispiel der vorliegenden Erfindung;
Fig. 5 einen weiteren Detailausschnitt der Leuchtdiodenvorrichtung aus Fig. 3, gemäß einem Ausführungsbeispiel der vorliegenden Erfindung;
Fig. 6 eine vergrößerte Darstellung einer Vorderseite eines Leuchtdiodenelements der Leuchtdiodenvorrichtung aus Fig. 2, gemäß einem Ausführungsbeispiel der vorliegenden Erfindung;
Fig. 7 eine schematische Darstellung einer Leuchtdiodenvorrichtung gemäß einem weiteren Ausführungsbeispiel;
Fig. 8 eine Darstellung eines Leuchtdiodenelements gemäß einem Ausführungsbeispiel;
Fig. 9 eine Draufsicht auf eine Leuchtdiodenvorrichtung gemäß einem weiteren Ausführungsbeispiel;
Fig. 10 eine Seitenansicht der Leuchtdiodenvorrichtung aus Fig. 8;
Fig. 11 eine Untenansicht der Leuchtdiodenvorrichtung aus Fig. 8;
Fig. 12 einen Detailausschnitt der Leuchtdiodenvorrichtung aus Fig. 8;
Fig. 13 eine Darstellung eines Leuchtdiodenelements der Leuchtdiodenvorrichtung aus Fig. 8;
Fig. 14 ein Ablaufdiagramm eines Verfahrens zum Herstellen einer Leuchtdiodenvorrichtung, gemäß einem Ausführungsbeispiel der vorliegenden Erfindung;
Fig. 15 eine Explosionsdarstellung einer gemäß dem Verfahren aus Fig. 14 herzustellenden Leuchtdiodenvorrichtung, mit Blick auf eine erste Hauptseite der Elemente, gemäß einem Ausführungsbeispiel der vorliegenden Erfindung; und
Fig. 16 eine Explosionsdarstellung einer gemäß dem Verfahren aus Fig. 14 herzustellenden Leuchtdiodenvorrichtung, mit Blick auf eine zweite Hauptseite der Elemente, gemäß einem Ausführungsbeispiel der vorliegenden Erfindung.
Fig. 17 eine weitere vorteilhafte Ausführungsform einer Leuchtdiodenvorrichtung gemäß einem weiteren Ausführungsbeispiel der vorliegenden Erfindung;
Fig. 18 eine weitere vorteilhafte Ausführungsform einer Leuchtdiodenvorrichtung gemäß einem weiteren Ausführungsbeispiel der vorliegenden Erfindung;

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

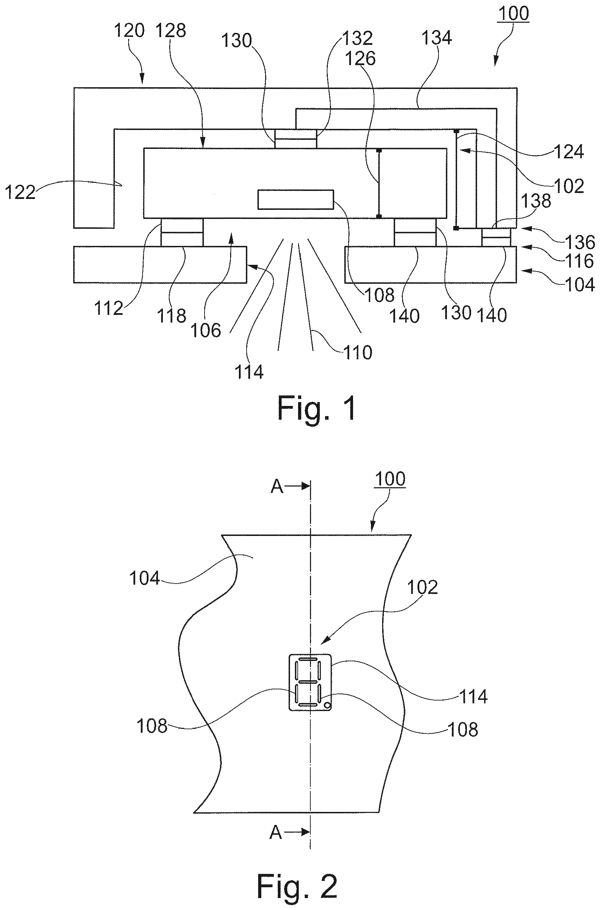

Fig. 1 zeigt eine schematische Darstellung einer Leuchtdiodenvorrichtung 100 gemäß einem Ausführungsbeispiel der vorliegenden Erfindung. Die Leuchtdiodenvorrichtung 100 umfasst ein Leuchtdiodenelement 102 sowie eine Leiterplatte 104. Bei der Leuchtdiodenvorrichtung 100 kann es sich um einen LED-Chip oder einen Teil eines LED-Chips zum Anzeigen einer Text- oder Zahleninformation handeln. Die Leiterplatte 104 wird zur mechanischen Befestigung und elektrischen Verbindung des Leuchtdiodenelements 102 eingesetzt.

Eine Vorderseite 106 des Leuchtdiodenelements 102, die in der Darstellung in Fig. 1 nach unten gerichtet ist, weist einen Emissionsbereich 108 zum Emittieren elektromagnetischer Wellen 110, z. B. Licht, auf. Ferner weist die Vorderseite 106 einen dem Emissionsbereich 108 zugeordneten Diodenanschlusskontakt 112 auf. Bei dem in Fig. 1 gezeigten Ausführungsbeispiel bildet der Diodenanschlusskontakt 112 die Anode des Leuchtdiodenelements 102. Der Diodenanschlusskontakt 112 ist benachbart zu dem Emissionsbereich 108 auf der Vorderseite 106 des Leuchtdiodenelements 102 angeordnet.

Die Leiterplatte 104 weist eine Durchgangsöffnung 114 auf. Bei der in Fig. 1 gezeigten gestapelten Anordnung aus Leiterplatte 104 und Leuchtdiodenelement 102 ist das Leuchtdiodenelement 102 so auf der Leiterplatte 104 angeordnet, dass der Emissionsbereich 108 der Durchgangsöffnung 114 gegenüberliegt. Bei einem Stromfluss durch das Leuchtdiodenelement 102 können somit die elektromagnetischen Wellen 110 frei - in der Darstellung in Fig. 1 nach unten - abstrahlen. Ferner weist die Leiterplatte 104 auf einer in der in Fig. 1 gezeigten Anordnung dem Leuchtdiodenelement 102 zugewandten Seite 116 einen Plattenanschlusskontakt 118 auf. In der in Fig. 1 gezeigten Anordnung ist der Plattenanschlusskontakt 118 gegenüber dem Diodenanschlusskontakt 112 angeordnet und elektrisch leitend mit diesem verbunden. Über die Anschlusskontakte 112, 118 liegt das Leuchtdiodenelement 102 mit der Vorderseite 106 auf der Leiterplatte 104 auf und ist mit dieser verbunden.

Bei dem in Fig. 1 gezeigten Ausführungsbeispiel der Leuchtdiodenvorrichtung 100 ist die Stapelanordnung aus Leiterplatte 104 und Leuchtdiodenelement 102 erweitert um eine Abdeckeinheit 120, die angrenzend an das Leuchtdiodenelement 102 angeordnet ist. Auf einer dem Leuchtdiodenelement 102 zugewandten Seite weist die Abdeckeinheit 120 eine Ausnehmung 122 auf, die das Leuchtdiodenelement 102 aufnimmt. Das Leuchtdiodenelement 102 wird damit durch die Abdeckeinheit 120 haubenartig abgedeckt. Bei der Ausnehmung 122 handelt es sich um eine Vertiefung in der Abdeckeinheit 120, die in ihrer Form dem Leuchtdiodenelement 102 entspricht, zum geeigneten Aufnehmen des Leuchtdiodenelements 102 jedoch größere Abmessungen als dieses aufweist. Insbesondere ist eine Tiefe 124 der Ausnehmung 122 größer als eine Dicke 126 des Leuchtdiodenelements 102. Bei dem in Fig. 1 gezeigten Ausführungsbeispiel ist die Abdeckeinheit 120 einteilig ausgeführt.

Bei dem in Fig. 1 gezeigten Ausführungsbeispiel der Leuchtdiodenvorrichtung 100 ist das Leuchtdiodenelement 102 über die Vorder- und Rückseite elektrisch kontaktiert. Entsprechend weist eine Rückseite 128 des Leuchtdiodenelements 102 einen zweiten Diodenanschlusskontakt 130 auf. Der zweite Diodenanschlusskontakt 130 bildet bei dem beispielhaften Leuchtdiodenelement 102 in Fig. 1 die Kathode. Die Abdeckeinheit 120 verfügt in der Ausnehmung 122 über einen Abdeckeinheitskontakt 132. Der Abdeckeinheitskontakt 132 ist gegenüber dem zweiten Diodenanschlusskontakt 130 angeordnet mit diesem elektrisch leitfähig verbunden.

Zur Versorgung der Kontaktgruppe 130, 132 mit elektrischer Spannung ist der Abdeckeinheitskontakt 132 mittels einer in dem Abdeckelement 120 angelegten elektrischen Leitung 134, beispielsweise einer Metallisierung, mit einer weiteren Kontaktgruppe 136 elektrisch leitfähig verbunden. Bei der weiteren Kontaktgruppe 134 handelt es sich hier um einen weiteren Abdeckeinheitskontakt 138 und einen zweiten Plattenanschlusskontakt 140, der wie der erste Plattenanschlusskontakt 118 an der dem Leuchtdiodenelement 102 zugewandten Seite 116 der Leiterplatte 104 angeordnet ist. Der weitere Abdeckeinheitskontakt 138 ist elektrisch leitfähig mit der elektrischen Leitung 134 verbunden. Der weitere Abdeckeinheitskontakt 138 und der zweite Plattenanschlusskontakt 140 sind einander gegenüberliegend in der Vorrichtung 100 angeordnet und elektrisch leitfähig verbunden.

In einem nicht erfindungsgemäßen Beispiel können sowohl die Anode 112 also auch die Kathode 130 des Leuchtdiodenelements 102 vorderseitig kontaktiert sein. Diese Ausführungsform ist beispielhaft ebenfalls in Fig. 1 gezeigt.

Zur vorderseitigen Kontaktierung der Kathode 130 des Leuchtdiodenelements 102 ist der zweite Diodenanschlusskontakt 130 wie der erste Diodenanschlusskontakt 112 an der Vorderseite 106 des Leuchtdiodenelements 102 angeordnet. Bei dem in Fig. 1 gezeigten Ausführungsbeispiel befindet sich der zweite Diodenanschlusskontakt 130 benachbart zu dem Emissionsbereich 108, so, dass der Emissionsbereich 108 zwischen dem Diodenanschlusskontakt 112 und dem zweiten Diodenanschlusskontakt 130 positioniert ist. Entsprechend dieser Option ist der zweite Plattenanschlusskontakt 140 so an der Hauptseite 116 der Leiterplatte 104 angelegt, dass sich der zweite Diodenanschlusskontakt 130 und der zweite Plattenanschlusskontakt 140 gegenüberliegen und elektrisch kontaktiert sind.

Bei dieser zweiten Option der Kontaktierung des Leuchtdiodenelements 102 dient die Abdeckeinheit 120 lediglich der Befestigung und/oder dem Schutz des Leuchtdiodenelements 102 vor mechanischen Einwirkungen von außen.

Anode 112 und Kathode 130 des Leuchtdiodenelements 102 können gemäß Ausführungsbeispielen auch vertauscht sein.

Fig. 2 zeigt eine Draufsicht auf eine weitere beispielhafte Leuchtdiodenvorrichtung 100 gemäß dem hier vorgestellten Konzept. Gezeigt ist ein Ausschnitt aus der Leiterplatte 104 mit der Durchgangsöffnung 114, die den Blick auf eine Mehrzahl von sieben Emissionsbereichen 108 des in der Darstellung in Fig. 2 hinter der Leiterplatte 104 angeordneten Leuchtdiodenelements 102 freigibt. Die Emissionsbereiche 108 bilden bei dem in Fig. 2 gezeigten Ausführungsbeispiel der Leuchtdiodenvorrichtung 100 eine Anzeige eines als 7-Segment-Anzeigediode ausgeführten Leuchtdiodenelements bzw. LED-Chips 102. Der Übersichtlichkeit halber sind in der Darstellung lediglich zwei der insgesamt sieben Emissionsbereiche 108 mit einem Bezugszeichen versehen. Auf diese spezielle Ausführung des Leuchtdiodenelements 102 als 7-Segment-Anzeigediode wird anhand nachfolgender Figuren noch detaillierter eingegangen. Der Übersichtlichkeit halber wird nachfolgend lediglich eine der Mehrzahl von Kontaktierungen der 7-Segment-Anzeigediode erläutert.

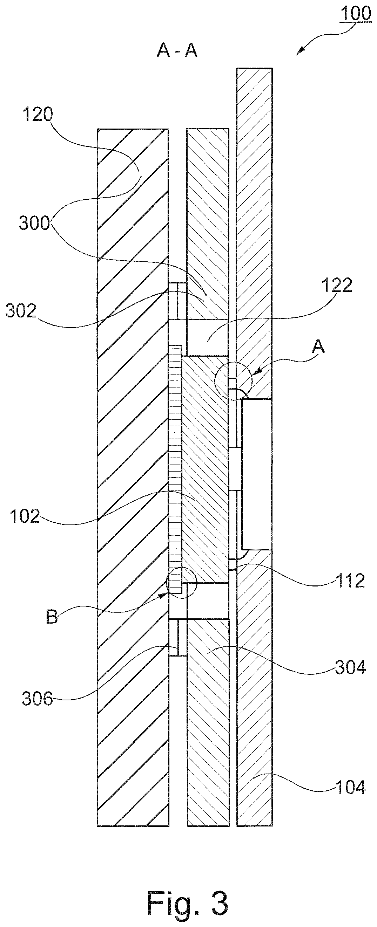

Fig. 3 zeigt eine Schnittdarstellung der beispielhaften Leuchtdiodenvorrichtung 100 aus Fig. 2 entlang einer Schnittlinie A-A in Fig. 2. Hier ist der Stapelaufbau aus Leiterplatte 104, Leuchtdiodenelement bzw. LED-Chip 102 und Abdeckeinheit 120 gut zu erkennen. Die Abdeckeinheit 120 kann auch als Abdeckplatine bezeichnet werden.

Bei der in Fig. 3 gezeigten Leuchtdiodenvorrichtung 100 ist die Abdeckeinheit 120 erfindungsgemäß zweiteilig ausgeführt und setzt sich aus einer weiteren Leiterplatte 300 und einem an der weiteren Leiterplatte 300 anliegenden Rahmenelement 302 zusammen. Hierbei wird die Ausnehmung 122 zum Aufnehmen des Leuchtdiodenelements 102 durch eine Durchtrittsöffnung 304 in dem Rahmenelement 302 gebildet. Das Rahmenelement 302 erfüllt damit den Zweck einer Abstandsplatine zwischen der Leiterplatte 104 und der weiteren Leiterplatte 300 zur Unterbringung des LED-Chips 102 zwischen den Leiterplatten 104, 300.

Wie die Darstellung in Fig. 3 zeigt, sind die weitere Leiterplatte 300 und das Rahmenelement 302 über zwischen ihnen angeordnete Verbindungsplättchen 306 aneinander gekoppelt. Wie die Darstellung in Fig. 3 zeigt, weist auch hier die durch die weitere Leiterplatte 300 und das Rahmenelement 302 gebildete Ausnehmung 122 eine Tiefe auf, die größer als eine Dicke des LED-Chips 102 ist.

Bei dem in Fig. 3 gezeigten Ausführungsbeispiel der Leuchtdiodenvorrichtung 100 ist das Leuchtdiodenelement 102 mit der Anode 112 vorderseitig elektrisch und mechanisch kontaktiert. Die Kathode - in Fig. 3 nicht gezeigt - ist mit der Abdeckplatine 120 elektrisch kontaktiert und über - in Fig. 3 ebenfalls nicht gezeigte - Durchkontaktierungen in dem Rahmenelement 302 auf die Vorderseite des Leuchtdiodenelements 102 geführt.

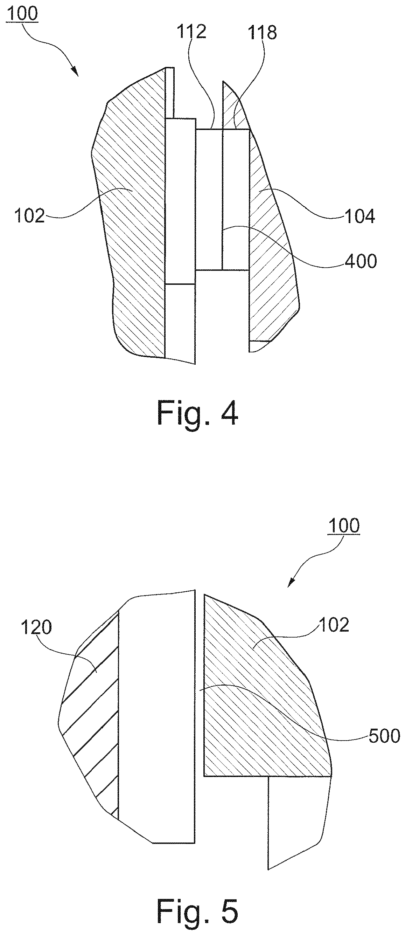

Fig. 4 zeigt einen in Fig. 3 mit dem Bezugszeichen A gekennzeichneten Detailausschnitt der beispielhaften Leuchtdiodenvorrichtung 100. Gezeigt ist die elektrische und mechanische Verbindung zwischen dem LED-Chip 102 und der Leiterplatte 104. Gut ersichtlich ist, dass sich der erste Diodenanschlusskontakt 112 des LED-Chips 102 und der erste Plattenanschlusskontakt 118 der Leiterplatte 104 genau ausgerichtet gegenüberliegen und einander an einer gemeinsamen Grenzfläche 400 berühren. Über die Grenzfläche 400 sind der erste Diodenanschlusskontakt 112 und der erste Plattenanschlusskontakt 118 elektrisch und mechanisch miteinander verbunden.

Fig. 5 zeigt einen in Fig. 3 mit dem Bezugszeichen B gekennzeichneten weiteren Detailausschnitt der beispielhaften Leuchtdiodenvorrichtung 100. Gezeigt ist die elektrische und mechanische Verbindung zwischen dem LED-Chip 102 und der Abdeckplatine 120. Bei dem gezeigten Ausführungsbeispiel der Leuchtdiodenvorrichtung 100 ist in einem Spalt zwischen einander gegenüberliegenden Seiten des Leuchtdiodenelements 102 und der Abdeckeinheit 120 eine elektrisch leitfähige Kontaktierungsschicht 500 vorgesehen. Der Spalt zum Aufnehmen der Kontaktierungsschicht 500 ist aufgrund der geringeren Dicke des Leuchtdiodenelements 102 gegenüber der Tiefe der in der Abdeckeinheit 120 vorgesehenen Ausnehmung gegeben.

Gemäß unterschiedlichen Ausführungsbeispielen der Leuchtdiodenvorrichtung 100 wird die elektrisch leitfähige Kontaktierungsschicht 500 durch einen elektrischen Leitkleber, einen anisotropen Kleber, einen Silikonkleber, einen Grafitschaum oder durch Sinterlöten ohne Druck gebildet.

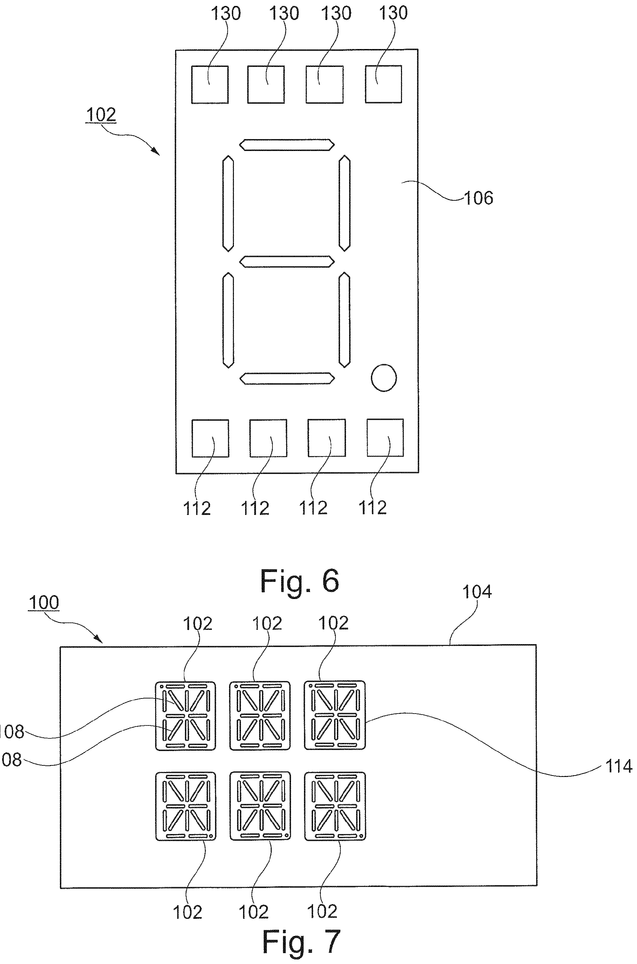

Fig. 6 zeigt die Vorderseite 106 des beispielhaften Leuchtdiodenelements 102 gegenüber der Darstellung in Fig. 2 in einer vergrößerten Ansicht und ohne die teilweise Abdeckung durch die Leiterplatte. Hier ist gut zu erkennen, dass sowohl die ersten Diodenanschlusskontakte bzw. Anoden 112 als auch die zweiten Diodenanschlusskontakte 130 bzw. Kathoden des Leuchtdiodenelements 102 für eine vorderseitige Kontaktierung des Leuchtdiodenelements 102 nach vorn geführt sind.

Die Figuren 2 bis 6 zeigen ein Kontaktierungsbeispiel für eine Ausführung der hierin vorgeschlagenen Leuchtdiodenvorrichtung 100 als 7-Segment-Anzeigechip mit n Kontakten auf der Rückseite des Leuchtdiodenelements 102. Die elektrische Kontaktierung der Anoden 112 mit der ersten Leiterplatte 104 kann z. B. durch Thermokompression erfolgen. Die Leiterplatte 104 kann z. B. aus Polyimid, aus glasfaserverstärktem Epoxidharz, etc. gebildet sein. Die Rückseite der Display-LED-Chips 102 ist mit dem Kontaktmaterial 500 verbunden und über den Rahmen 302 mit Durchkontaktierungen auf die erste Leiterplatte 104 geführt, auf der auch die Anoden 112 geführt werden. Als das Kontaktmaterial 500 kann Leitkleber, Sinterpaste, anisotroper Kleber, Grafitschaum, elektrische Leitpaste, etc. verwendet werden.

Gemäß einem alternativen Ausführungsbeispiel kann die Rückseitenkontaktierung auch über ein Drahtbond-Verfahren durchgeführt werden. Die Kontaktierung und Entflechtung ist durch eine mehrlagige Ausführung der weiteren Leiterplatte 300 auf der Rückseite vorgesehen. Die weitere Leiterplatte 300 bildet zusammen mit der Abstandsplatine 302 die Abdeckplatine 120. Dabei hat die Abstandsplatine 302 Aussparungen und ist dicker als die Chips 102. Die Abdeckplatine 120 ist geschlossen und dient zum Schutz der LED-Anordnung 102 zur Rückseite, kann aber auch zum weiteren elektrischen Anschluss, beispielsweise über einen Stecker, an eine Ansteuereinheit verwendet werden.

Fig. 7 zeigt eine schematische Darstellung einer Leuchtdiodenvorrichtung 100 gemäß einem nicht erfindungsgemäßen Beispiel. Die Draufsicht in Fig. 7 zeigt, dass dieses Ausführungsbeispiel der Leuchtdiodenvorrichtung 100 eine Mehrzahl von sechs Leuchtdiodenelementen 102 aufweist. Die Leuchtdiodenelemente 102 sind hier jeweils als 16-Segment-Anzeigechips ausgeführt und in zwei Reihen von je drei Chips 102 untereinander angeordnet. Jedes Leuchtdiodenelement 102 weist 16 Emissionsbereiche 108 auf, von den denen der Übersichtlichkeit halber lediglich zwei in der Darstellung mit einem Bezugszeichen versehen sind.

Entsprechend der Anzahl von Leuchtdiodenelementen 102 sind in der Leiterplatte 104 sechs Durchgangsöffnungen 114 vorgesehen, von denen der Übersichtlichkeit halber lediglich eine in der Darstellung mit einem Bezugszeichen versehen ist. Die sechs Durchgangsöffnungen 114 sind so in der Leiterplatte 104 angeordnet, dass sie den Blick auf die Emissionsbereiche 108 der Leuchtdiodenelemente 102 freigeben. Über in der Darstellung in Fig. 7 nicht gezeigte zusätzliche Plattenanschlusskontakte sind ebenfalls nicht gezeigte zusätzliche Diodenanschlusskontakte der Leuchtdiodenelemente 102 mit der Leiterplatte 104 elektrisch leitend kontaktiert.

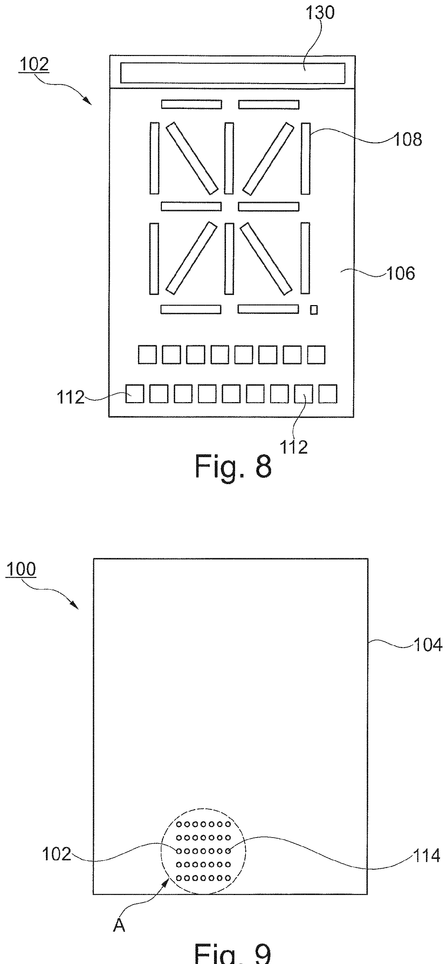

Fig. 8 zeigt eine detaillierte Darstellung einer beispielhaften Vorderseite 106 eines der sechs Leuchtdiodenelemente 102 des in Fig. 7 vorgestellten nicht erfindungsgemäßen Ausführungsbeispiels der Leuchtdiodenvorrichtung 100. In der gegenüber der Darstellung in Fig. 7 vergrößerten Ansicht ist die Vorderseite 106 ohne die teilweise Abdeckung durch die Leiterplatte gezeigt. Hier ist gut zu erkennen, dass den 16 Emissionsbereichen 108 eine Mehrzahl von n Diodenanschlusskontakten 112 zugeordnet ist. Die Diodenanschlusskontakte 112 bilden bei dem in Fig. 8 gezeigten Ausführungsbeispiel die Anoden der Leuchtdiodenelemente 102. Der Übersichtlichkeit halber sind lediglich zwei der Diodenanschlusskontakte 112 in Fig. 8 mit einem Bezugszeichen versehen.

Alle 16 Emissionsbereiche 108 verfügen bei dem in Fig. 8 gezeigten nicht erfindungsgemäßen Ausführungsbeispiel über einen gemeinsamen zweiten Diodenanschlusskontakt 130, der hier die Kathode der Leuchtdiodenelemente 102 bildet. Wie die Darstellung in Fig. 8 zeigt, sind sowohl die ersten Diodenanschlusskontakte bzw. Anoden 112 als auch der zweite Diodenanschlusskontakt 130 bzw. die Kathode des Leuchtdiodenelements 102 für eine vorderseitige Kontaktierung des Leuchtdiodenelements 102 nach vorn geführt.

Bei dem in den Figuren 7 und 8 gezeigten Ausführungsbeispiel der Leuchtdiodenvorrichtung 100 ist diese als ein 2x3x16-Segment-Anzeigchip ausgeführt, bei dem die Anoden 112 und Kathoden 130 auf der gleichen Seite 106 gelötet sind. Die Kontaktierung der Anoden 112 und Kathoden 130 kann gemäß Ausführungsbeispielen durch Löten, Kleben oder Thermokompressionsbonden der sechs 16-Segment-Anzeigechips 102 in zwei Reihen auf die erste Leiterplatte 104 mit den Öffnungen 114 zum Betrachten der Emissionsgebiete 108 der LED-Anzeigechips 102 gestaltet sein. Anoden 112 und Kathoden 130 der LED-Chips 102 sind in diesem nicht erfindungsgemäßen Beispiel nach oben geführt. Somit ist ein Rückseitenkontakt der LED-Chips 102 nicht notwendig.

Die in den Figuren 7 und 8 nicht gezeigte zweite Leiterplatte verfügt entweder über Aussparungen für die Chips 102 oder besteht aus zwei nacheinander verbundenen Leiterplatten, von denen die erste Öffnungen für die Chips 102 aufweist und dicker als die Chips 102 ist und die zweite geschlossen ist. Sie dienen zum Schutz der LED-Anordnung nach hinten. Werden gemäß alternativen Ausführungsbeispielen Anoden 112 und Kathoden 130 der LED-Chips 102 nicht nach vorne geführt, erfolgt eine Rückseitenkontaktierung, wie sie im Zusammenhang mit Fig. 1 erläutert ist.

Fig. 9 zeigt eine Draufsicht auf eine Leuchtdiodenvorrichtung 100 gemäß einem weiteren Ausführungsbeispiel. Hier ist ein fünfzeiliges Array von 35 Leuchtdiodenelementen 102 zur Bildung einer 5x7-Dot-Matrix vorgesehen. Der Übersichtlichkeit halber ist lediglich ein Leuchtdiodenelement 102 mit einem Bezugszeichen versehen. Wie bei den vorherigen Ausführungsbeispielen ist auch hier eine der Mehrzahl von Leuchtdiodenelementen 102 entsprechende Mehrzahl von geeignet positionierten Durchgangsöffnungen 114 in der Leiterplatte 104 vorgesehen, die den Blick auf die Emissionsbereiche der Leuchtdiodenelemente 102 freigibt.

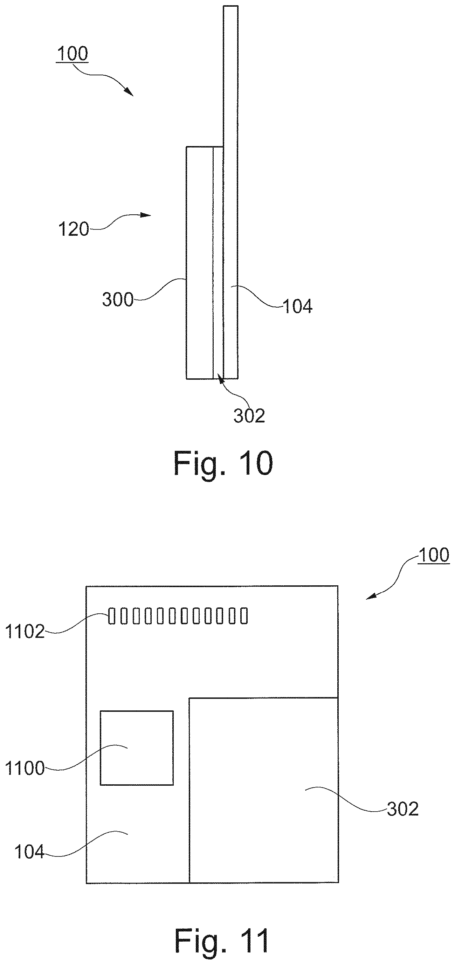

Fig. 10 zeigt in einer Seitenansicht einen Stapelaufbau der beispielhaften Leuchtdiodenvorrichtung 100 aus Fig. 9. Auch bei diesem Ausführungsbeispiel ist die Leiterplatte 104 mit einer Abdeckeinheit 120 verbunden, wobei die in Fig. 10 nicht gezeigten Leuchtdiodenelemente in einer in Fig. 10 ebenfalls nicht gezeigten Ausnehmung in der Abdeckeinheit 120 angeordnet sind. Wie bei dem in Fig. 3 gezeigten Ausführungsbeispiel setzt sich auch hier die Abdeckeinheit 120 aus einer weiteren Leiterplatte 300 und einem als Abstandsplatine dienenden Rahmenelement 302 zusammen.

Fig. 11 zeigt eine Untenansicht bzw. Rückseite der Leuchtdiodenvorrichtung 100 aus Fig. 9. Gezeigt sind eine auf einer Rückseite der Leiterplatte 104 neben der Abdeckplatine bzw. dem Rahmenelement 302 angeordnete Treiberschaltung 1100 zum Ansteuern des Leuchtdiodenelements sowie eine Mehrzahl von Treiberkontakten 1102 zum elektrischen Kontaktieren der Treiberschaltung 1100.

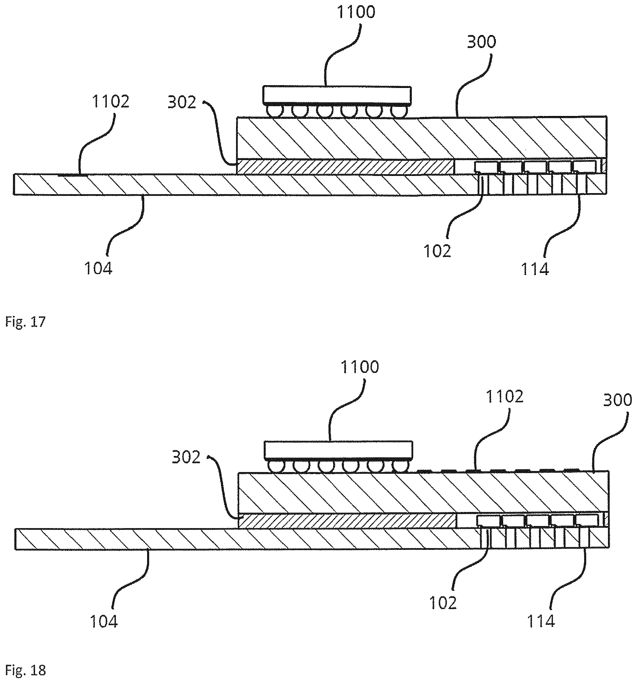

Fig. 17 zeigt eine Schnittdarstellung der Leuchtdiodenvorrichtung eines weiteren vorteilhaften Ausführungsbeispiels der vorliegenden Erfindung. Gezeigt sind eine auf einer Rückseite der weiteren Leiterplatte 300 angeordnete Treiberschaltung 1100 zum Ansteuern des Leuchtdiodenelements sowie eine auf der Leiterplatte 104 angeordnete Mehrzahl von Treiberkontakten 1102 zum elektrischen Kontaktieren der Treiberschaltung 1100. Das Rahmenelement und die weitere Leiterplatte weisen zur elektrischen Verbindung Durchkontaktierungen auf (nicht dargestellt) Die Leuchtdiodenvorrichtung dieses Ausführungsbeispiels weist mehrere Durchgangsöffnungen 114 und mehrere Leuchtdiodenelemente 102 auf. In weiteren Abwandlungen (nicht dargestellt) können auch nur eine Durchgangsöffnung und/oder nur ein Leuchtdiodenelement vorhanden sein.

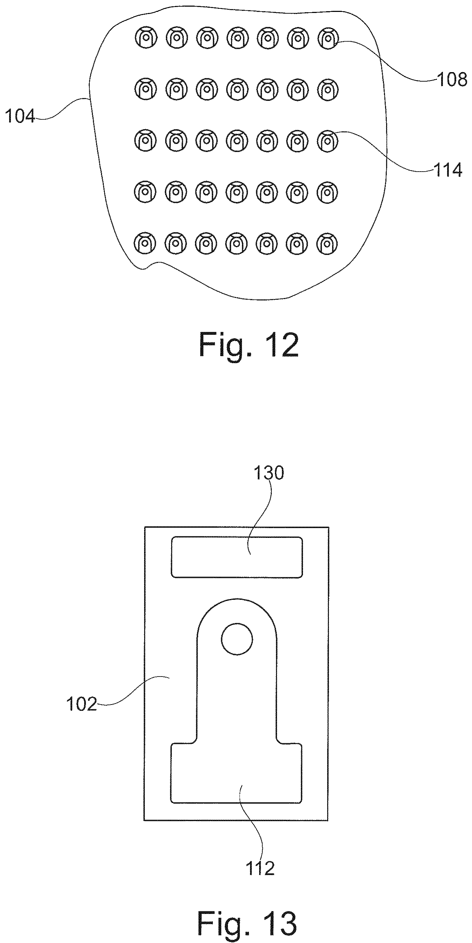

Fig. 18 zeigt eine weitere Abwandlung des Ausführungsbeispiels nach Fig. 17. In diesem Ausführungsbeispiel sind die Mehrzahl von Treiberkontakten 1102 auf der weiteren Leiterplatte 300 angeordnet. Fig. 12 zeigt einen in Fig. 9 mit dem Bezugszeichen A gekennzeichneten Detailausschnitt der Leuchtdiodenvorrichtung 100, gemäß einem Ausführungsbeispiel der vorliegenden Erfindung. Hier ist gut zu erkennen, dass es sich bei der Mehrzahl von die Dot-Matrix bildenden Leuchtdiodenelementen 102 um LED-Punktstrahler handelt. Bei dem in der Darstellung gezeigten Ausführungsbeispiel weisen die jeweiligen Emissionsbereiche 108 der Punktstrahler 102 eine Emissionsfläche mit einem Durchmesser von 100 µm auf. Dieser Durchmesser ist optional und kann auch größer oder kleiner gestaltet werden. Die Leiterplatte 104 ist so gegenüber dem Array von Leuchtdiodenelementen 102 positioniert, dass die Emissionsbereiche 108 jeweils mittig gegenüber den Konturen der Durchgangsöffnungen 114 in der Leiterplatte 104 ausgerichtet sind.

Fig. 13 zeigt in einer Prinzipdarstellung einen der beispielhaften Punktstrahler 102 der 5x7-Dot-Matrix-LED aus Fig. 9. Wiederum sind der Diodenanschlusskontakt 112 und der zweite Diodenanschlusskontakt 130 für eine Vorderseitenkontaktierung des LED-Chips 102 nach vorn geführt.

Bei dem in den Figuren 9 bis 13 vorgestellten nicht erfindungsgemäßen Ausführungsbeispiel der Leuchtdiodenvorrichtung 100 handelt es sich um eine alphanumerische 5x7-Dot-Matrix-LED. Die hier 35 LED-Chips 102 sind zur Bildung einer 5x7-Dot-Matrix durch Löten, Kleben oder Thermokompressionsbonden auf die erste Leiterplatte 104 mit Öffnungen 114 zum Betrachten der Emissionsgebiete 108 kontaktiert. Als die LED-Chips 102 sind in diesem Beispiel Punktstrahler mit einer kreisförmigen Emissionsfläche eines Durchmessers von 100 µm ausgewählt. Die Anode 112 und Kathode 130 der LED-Chips 102 sind in diesem Beispiel nach oben geführt. Somit ist eine Rückseitenkontaktierung des LED-Chips 102 nicht notwendig. Die Führung der Leiterbahnen und der Anschluss elektrischer Schnittstellen, beispielsweise Stecker, und Ansteuereinheiten, beispielsweise der LED-Treiber 1100, können sowohl auf der ersten Leiterplatte 104 als auch auf der zweiten Leiterplatte 300 erfolgen.

Die Abdeckeinheit 120 weist entweder Aussparungen für die Chips 102 auf oder besteht aus zwei nacheinander verbundenen Leiterplatten 300, 302, von denen die erste Öffnungen für die Chips 102 aufweist und dicker als die Chips 102 ausgeführt ist und die zweite geschlossen ist. Sie dienen zum Schutz der LED-Anordnung 102 nach hinten. Werden gemäß alternativen Ausführungsbeispielen Anoden 112 und Kathoden 130 der LED-Chips 102 nicht nach vorne geführt, erfolgt eine Rückseitenkontaktierung, wie sie im Zusammenhang mit Fig. 1 erläutert ist.

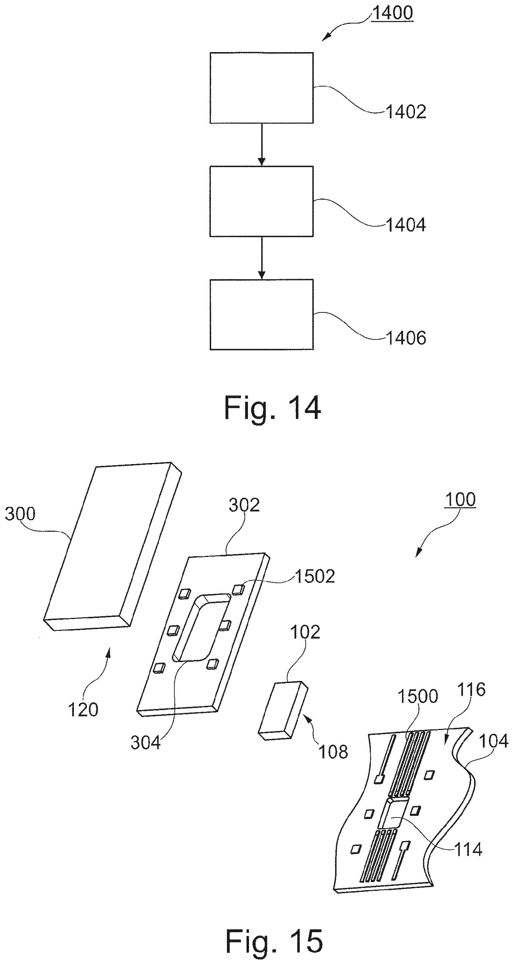

Fig. 14 zeigt ein Ablaufdiagramm eines Ausführungsbeispiels eines Verfahrens 1400 zum Herstellen einer Leuchtdiodenvorrichtung. Das Verfahren 1400 kann zum Herstellen einer der in den vorangegangenen Figuren vorgestellten beispielhaften Leuchtdiodenvorrichtungen 100 ausgeführt werden.

In einem Schritt des Bereitstellens 1402 wird ein Leuchtdiodenelement mit einer Vorderseite und einer Rückseite bereitgestellt. Dabei weist die Vorderseite einen Emissionsbereich zum Emittieren elektromagnetischer Wellen und einen dem Emissionsbereich zugeordneten Diodenanschlusskontakt auf. In einem weiteren Schritt des Bereitstellens 1404 wird eine Leiterplatte mit einer Durchgangsöffnung und einem Plattenanschlusskontakt bereitgestellt. In einem Schritt des Fügens 1406 wird die Vorderseite des Leuchtdiodenelements mit der Leiterplatte so verbunden, dass der Emissionsbereich gegenüber der Durchgangsöffnung angeordnet wird und der Diodenanschlusskontakt gegenüber dem Plattenanschlusskontakt angeordnet wird und elektrisch leitend mit dem Plattenanschlusskontakt verbunden wird.

Fig. 15 zeigt eine Explosionsdarstellung einer gemäß einem Ausführungsbeispiel des Verfahrens 1400 aus Fig. 14 herzustellenden beispielhaften Leuchtdiodenvorrichtung 100. Gezeigt sind die Leiterplatte 104 mit der Durchgangsöffnung 114, das Leuchtdiodenelement 102 sowie die sich aus der weiteren Leiterplatte 300 und dem Rahmenelement 302 zusammensetzende Abdeckeinheit 120. Die Leiterplatte 104 ist mit Blick auf die dem Leuchtdiodenelement 102 zuzuwendende Seite 116 gezeigt. Diese Seite 116 der Leiterplatte 104 weist elektrische Leitungen 1500 für eine Kontaktierung der Leiterplatte 104 auf.

Auf die Seite 116 der Leiterplatte 104 wird im Fertigungsprozess im Schritt des Fügens 1406 das Leuchtdiodenelement 102 mit dem Emissionsbereich 108 nach unten gegenüber der Durchgangsöffnung 114 ausgerichtet aufgelegt. Anschließend wird das Rahmenelement 302 so auf die Seite 116 der Leiterplatte 104 aufgelegt, dass das Leuchtdiodenelement 102 in die Durchtrittsöffnung 304 des Rahmenelements 302 aufgenommen wird. Das in Fig. 15 gezeigte beispielhafte Rahmenelement 302 weist Durchkontaktierungen 1502 zum Führen einer Kathode des Leuchtdiodenelements 102 nach vorn auf die Leiterplatte 104 auf. Zuletzt wird zur elektrischen Kontaktierung und/oder zum Schutz des Leuchtdiodenelements 102 die weitere Leiterplatte 300 auf das Rahmenelement 302 aufgelegt und mit diesem verbunden.

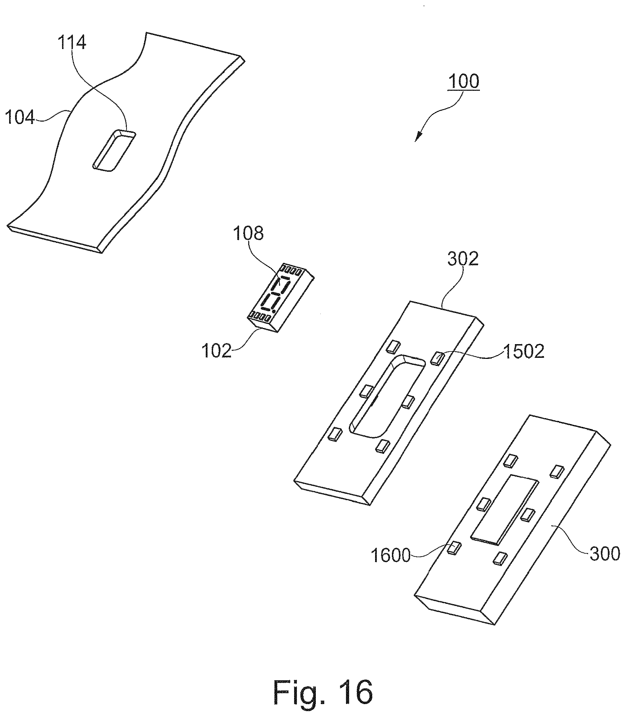

Fig. 16 zeigt anhand einer weiteren Explosionsdarstellung die LED-Anordnung 100 aus Fig. 15 aus einer zu der Blickrichtung in Fig, 15 entgegengesetzten Blickrichtung betrachtet. Hier ist der Emissionsbereich 108 des Leuchtdiodenelements 102 zu sehen, der im fertiggestellten Zustand der Leuchtdiodenvorrichtung 100 durch die Durchgangsöffnung 114 der Leiterplatte 104 für das Auge sichtbar ist. Wie die Darstellung in Fig. 16 zeigt, weist auch die weitere Leiterplatte 300 Durchkontaktierungen 1600 auf.

Gemäß einer Ausführungsform des Herstellungsverfahrens 1400 aus Fig. 14 wird der LED-Chip 102 im Schritt des Fügens 1406 mit der Emissionsseite 108 nach unten auf der Leiterplatte 104 elektrisch kontaktiert. Die Leiterplatte 104 weist die Öffnung 114 auf, die freie Sicht auf alle Emissionsbereiche 108 z. B. eines 7-Segment-Display-LED-Chips als das Leuchtdiodenelement 102 zulässt. Die elektrische Kontaktierung der einzelnen Emissionsbereiche 108, z. B. Segmente, Dezimalpunkt, kann beispielsweise durch verschiedene Lötverfahren oder Goldbump-Kompression erfolgen. Die Kontaktierungsflächen 1500 auf der Leiterplatte 104 entsprechen dabei in ihren Größen und Abständen exakt dem Bondkontaktmuster auf dem Display-LED-Chip 102.

Die Polarität der Display-LED-Chips 102 ist üblicherweise so, dass die Emissionsbereiche 108 als die Anode p-leitend sind und der Gegenkontakt auf der Chiprückseite als die Kathode n-leitend ist. Chips 102 mit umgekehrter Polarität werden ebenso aufgebaut, nur werden hier bei der Stromeinspeisung Anode und Kathode vertauscht.

Bei der hierin vorgestellten verbesserten LED-Chip-Anordnung 100 zur Miniaturisierung und Kostensenkung kann auf ein Drahtbond-Verfahren zur elektrischen Kontaktierung des Leuchtdiodenelements 102 verzichtet werden. Damit können beim mehrzeiligen Aufbau von Display-Arrays die Abstände zwischen einzelnen Leuchtdiodenelementen 102 so gering gestaltet werden, dass eine unverzerrte Einkopplung in optische Strahlengänge realisiert werden kann.

Bei der Darstellung von alphanumerischen Informationen kann mit der hier vorgestellten verbesserten LED-Chip-Anordnung 100 ein proportional angemessenes Erscheinungsbild der LED-Anzeige gewährleistet werden.

Auf ein Ziehen vieler Bonddrähte kann verzichtet werden, wodurch das Fehlerpotenzial reduziert und Bearbeitungszeiten verkürzt werden können. Ein Schutz von nach dem Drahtbonden offenen Bonddrähten durch zusätzliche Arbeitsschritte des Vergießens, Verkapselns und Abdeckens zur Gewährleistung der Stabilität kann ebenfalls entfallen.

Mit dem Verzicht auf die Bonddrähte treten Lichtreflexe, die die eigentlich wiederzugebenden Informationen stören und zu Irritationen beim Anwender führen können, nicht mehr auf. Eine bei der Verwendung von Bonddrähten zur Vermeidung von Irritationen übliche aufwendige Abdeckung der Bonddrähte mit absorbierendem Vergussmaterial oder mit einer Blendenkappe ist damit ebenfalls nicht mehr nötig.

Bei einer gemäß dem hier vorgestellten Konzept hergestellten Leuchtdiodenvorrichtung sinkt mit der Chipgröße nicht automatisch die Ausbeute an guten Chips, und die Kostenentwicklung bleibt in einem überschaubaren Rahmen. Die Problematik des mechanischen Schutzes und der Vermeidung von Reflexionen der Bonddrähte wurde kostengünstig gelöst.

Mit dem vorgeschlagenen Ansatz können ferner alle Digits eines Arrays individuelle Kontakte (Kathode oder Anode) aufweisen. Die Leuchtsegmente oder -punkte können einzeln oder gemeinsam kontaktiert und herausgeführt werden. Ferner können Multiplexschaltungen aufgebaut werden, die mit weniger elektrischen Anschlüssen betrieben werden können.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Leuchtdiodenvorrichtung (100), die die folgenden Merkmale aufweist:
ein Leuchtdiodenelement (102) mit einer Vorderseite (106) und einer Rückseite (128), wobei die Vorderseite (106) einen Emissionsbereich (108) zum Emittieren elektromagnetischer Wellen (110) und einen dem Emissionsbereich (108) zugeordneten Diodenanschlusskontakt (112) aufweist und die Rückseite (128) des Leuchtdiodenelements einen zweiten Diodenanschlusskontakt (130) aufweist;
und
eine Leiterplatte (104) mit einer Durchgangsöffnung (114) und einem Plattenanschlusskontakt (118), wobei die Vorderseite (106) des Leuchtdiodenelements (102) mit der Leiterplatte (104) verbunden ist, und wobei der Emissionsbereich (108) gegenüber der Durchgangsöffnung (114) angeordnet ist und der Diodenanschlusskontakt (112) gegenüber dem Plattenanschlusskontakt (118) angeordnet ist und elektrisch leitend mit dem Plattenanschlusskontakt (118) verbunden ist,
und mit einer Abdeckeinheit (120) mit einer Ausnehmung (122) zum Aufnehmen des Leuchtdiodenelements (102), wobei die Abdeckeinheit (120) mit der Leiterplatte (104) verbunden ist und das Leuchtdiodenelement (102) in der Ausnehmung (122) angeordnet ist und die Abdeckeinheit (120) einen Abdeckeinheitskontakt (132) aufweist und der Abdeckeinheitskontakt (132) gegenüber dem zweiten Diodenanschlusskontakt (130) angeordnet und elektrisch leitend mit dem zweiten Diodenanschlusskontakt (130) verbunden ist,
und bei der sich die Abdeckeinheit (120) aus einer weiteren Leiterplatte (300) und einem an der weiteren Leiterplatte (300) anliegenden Rahmenelement (302) zusammensetzt, wobei die Ausnehmung (122) durch eine Durchtrittsöffnung (304) in dem Rahmenelement (302) gebildet wird.

2. Leuchtdiodenvorrichtung (100) gemäß Anspruch 1, bei der die Vorderseite (106) des Leuchtdiodenelements (102) einen weiteren Emissionsbereich (108) zum Emittieren weiterer elektromagnetischer Wellen (110) und einen dem weiteren Emissionsbereich (108) zugeordneten weiteren Diodenanschlusskontakt (112) aufweist, wobei die Leiterplatte (104) einen weiteren Plattenanschlusskontakt (118) aufweist, und wobei der weitere Emissionsbereich (108) gegenüber der Durchgangsöffnung (114) angeordnet ist und der weitere Diodenanschlusskontakt (112) gegenüber dem weiteren Plattenanschlusskontakt (118) angeordnet ist und elektrisch leitend mit dem weiteren Plattenanschlusskontakt (118) verbunden ist.

3. Leuchtdiodenvorrichtung (100) gemäß einem der vorangegangenen Ansprüche, bei der eine Tiefe (124) der Ausnehmung (122) eine Dicke (126) des Leuchtdiodenelements (102) übersteigt.

4. Leuchtdiodenvorrichtung (100) gemäß einem der vorangegangenen Ansprüche, bei der die Abdeckeinheit (120) mittels einer elektrisch leitfähigen Kontaktierungsschicht (500) mit der Rückseite (128) des Leuchtdiodenelements (102) verbunden ist.

5. Leuchtdiodenvorrichtung (100) gemäß einem der vorangegangenen Ansprüche, bei der die Leiterplatte (104) einen zweiten Plattenanschlusskontakt (140) aufweist, und wobei die Abdeckeinheit (120) einen weiteren Abdeckeinheitskontakt (138) und eine die Abdeckeinheitskontakte (132, 138) elektrisch leitfähig verbindende elektrische Leitung (134) aufweist, wobei der weitere Abdeckeinheitskontakt (138) gegenüber dem zweiten Plattenanschlusskontakt (140) angeordnet ist und elektrisch leitend mit dem zweiten Plattenanschlusskontakt (140) verbunden ist.

6. Leuchtdiodenvorrichtung (100) gemäß einem der Ansprüche 1 bis 4, bei der die Vorderseite (106) des Leuchtdiodenelements (102) einen dem Emissionsbereich (108) zugeordneten zweiten Diodenanschlusskontakt (130) aufweist und die Leiterplatte (104) einen zweiten Plattenanschlusskontakt (140) aufweist, wobei der zweite Diodenanschlusskontakt (130) gegenüber dem zweiten Plattenanschlusskontakt (140) angeordnet ist und elektrisch leitend mit dem zweiten Plattenanschlusskontakt (140) verbunden ist.

7. Leuchtdiodenvorrichtung (100) gemäß einem der vorangegangenen Ansprüche, mit zumindest einem zusätzlichen Leuchtdiodenelement (102), wobei die Leiterplatte (104) zumindest eine zusätzliche Durchgangsöffnung (114) und zumindest einen zusätzlichen Plattenanschlusskontakt (118) aufweist, wobei ein zusätzlicher Emissionsbereich (108) des zusätzlichen Leuchtdiodenelements (102) gegenüber der zusätzlichen Durchgangsöffnung (114) angeordnet ist und ein zusätzlicher Diodenanschlusskontakt (112) des zusätzlichen Leuchtdiodenelements (102) gegenüber dem zusätzlichen Plattenanschlusskontakt (118) angeordnet ist und elektrisch leitend mit dem zusätzlichen Plattenanschlusskontakt (118) verbunden ist.

8. Leuchtdiodenvorrichtung (100) gemäß einem der vorangegangenen Ansprüche, mit einer Treiberschaltung (1100) zum Ansteuern des Leuchtdiodenelements (102) und zumindest einem Treiberkontakt (1102) zum elektrischen Kontaktieren der Treiberschaltung (1100), wobei die Treiberschaltung (1100) und/oder der Treiberkontakt (1102) an der Leiterplatte (104) angeordnet sind.

9. Leuchtdiodenvorrichtung (100) gemäß einem der vorangegangenen Ansprüche, mit einer Treiberschaltung (1100) zum Ansteuern des Leuchtdiodenelements (102) und zumindest einem Treiberkontakt (1102) zum elektrischen Kontaktieren der Treiberschaltung (1100), wobei die Treiberschaltung (1100) und/oder der Treiberkontakt (1102) an der weiteren Leiterplatte (300) angeordnet sind.

10. Verfahren (1400) zum Herstellen einer Leuchtdiodenvorrichtung (100), wobei das Verfahren (1400) die folgenden Schritte aufweist:
Bereitstellen (1402) eines Leuchtdiodenelements (102) mit einer Vorderseite (106) und einer Rückseite (128), wobei die Vorderseite (106) einen Emissionsbereich (108) zum Emittieren elektromagnetischer Wellen (110) und einen dem Emissionsbereich (108) zugeordneten Diodenanschlusskontakt (112) aufweist und die Rückseite (128) des Leuchtdiodenelements einen zweiten Diodenanschlusskontakt (130) aufweist;
Bereitstellen (1404) einer Leiterplatte (104) mit einer Durchgangsöffnung (114) und einem Plattenanschlusskontakt (118); und
Fügen (1406) des Leuchtdiodenelements (102) mit der Leiterplatte (104), wobei die Vorderseite (106) des Leuchtdiodenelements (102) mit der Leiterplatte (104) verbunden wird, und wobei der Emissionsbereich (108) gegenüber der Durchgangsöffnung (114) angeordnet wird und der Diodenanschlusskontakt (112) gegenüber dem Plattenanschlusskontakt (118) angeordnet wird und elektrisch leitend mit dem Plattenanschlusskontakt (118) verbunden wird; und
Bereitstellen einer Abdeckeinheit (120) mit einem Abdeckeinheitskontakt (132) und einer Ausnehmung (122) zum Aufnehmen des Leuchtdiodenelements (102), wobei sich die Abdeckeinheit (120) aus einer weiteren Leiterplatte (300) und einem an der weiteren Leiterplatte (300) anliegenden Rahmenelement (302) zusammensetzt, und wobei die Ausnehmung (122) durch eine Durchtrittsöffnung (304) in dem Rahmenelement (302) gebildet wird;
Anordnen des Abdeckeinheitskontakts (132) gegenüber dem zweiten Diodenanschlusskontakt (130),
Herstellen einer elektrisch leitenden Verbindung des Abdeckeinheitskontakts (132) mit dem zweiten Diodenanschlusskontakt (130).

## Claims

1. Light-emitting diode apparatus (100), which has the following features:
a light-emitting diode element (102) having a front side (106) and a rear side (128), wherein the front side (106) has an emission region (108) for the purpose of emitting electromagnetic waves (110) and a diode connection contact (112) associated with the emission region (108) and the rear side (128) of the light-emitting diode element has a second diode connection contact (130);
and
a printed circuit board (104) having a through-opening (114) and a board connection contact (118), wherein the front side (106) of the light-emitting diode element (102) is connected to the printed circuit board (104), and wherein the emission region (108) is arranged opposite the through-opening (114) and the diode connection contact (112) is arranged opposite the board connection contact (118) and is electrically conductively connected to the board connection contact (118),
and having a covering unit (120) having a recess (122) for the purpose of receiving the light-emitting diode element (102), wherein the covering unit (120) is connected to the printed circuit board (104) and the light-emitting diode element (102) is arranged in the recess (122) and the covering unit (120) has a covering unit contact (132) and the covering unit contact (132) is arranged opposite the second diode connection contact (130) and is electrically conductively connected to the second diode connection contact (130),
and in which the covering unit (120) is composed of a further printed circuit board (300) and a frame element (302) that abuts the further printed circuit board (300), wherein the recess (122) is formed by a passage opening (304) in the frame element (302).

2. Light-emitting diode apparatus (100) according to Claim 1, in which the front side (106) of the light-emitting diode element (102) has a further emission region (108) for the purpose of emitting further electromagnetic waves (110) and a further diode connection contact (112) associated with the further emission region (108), wherein the printed circuit board (104) has a further board connection contact (118), and wherein the further emission region (108) is arranged opposite the through-opening (114) and the further diode connection contact (112) is arranged opposite the further board connection contact (118) and is electrically conductively connected to the further board connection contact (118).

3. Light-emitting diode apparatus (100) according to either of the preceding claims, in which a depth (124) of the recess (122) exceeds a thickness (126) of the light-emitting diode element (102).

4. Light-emitting diode apparatus (100) according to one of the preceding claims, in which the covering unit (120) is connected to the rear side (128) of the light-emitting diode element (102) by means of an electrically conductive contact-connection layer (500).

5. Light-emitting diode apparatus (100) according to one of the preceding claims, in which the printed circuit board (104) has a second board connection contact (140), and wherein the covering unit (120) has a further covering unit contact (138) and an electrical line (134) that electrically conductively connects the covering unit contacts (132, 138), wherein the further covering unit contact (138) is arranged opposite the second board connection contact (140) and is electrically conductively connected to the second board connection contact (140).

6. Light-emitting diode apparatus (100) according to one of Claims 1 to 4, in which the front side (106) of the light-emitting diode element (102) has a second diode connection contact (130) associated with the emission region (108) and the printed circuit board (104) has a second board connection contact (140), wherein the second diode connection contact (130) is arranged opposite the second board connection contact (140) and is electrically conductively connected to the second board connection contact (140).

7. Light-emitting diode apparatus (100) according to one of the preceding claims, having at least one additional light-emitting diode element (102), wherein the printed circuit board (104) has at least one additional through-opening (114) and at least one additional board connection contact (118), wherein an additional emission region (108) of the additional light-emitting diode element (102) is arranged opposite the additional through-opening (114) and an additional diode connection contact (112) of the additional light-emitting diode element (102) is arranged opposite the additional board connection contact (118) and is electrically conductively connected to the additional board connection contact (118).

8. Light-emitting diode apparatus (100) according to one of the preceding claims, having a driver circuit (1100) for the purpose of driving the light-emitting diode element (102) and at least one driver contact (1102) for the purpose of electrically contact-connecting the driver circuit (1100), wherein the driver circuit (1100) and/or the driver contact (1102) are arranged on the printed circuit board (104).

9. Light-emitting diode apparatus (100) according to one of the preceding claims, having a driver circuit (1100) for the purpose of driving the light-emitting diode element (102) and at least one driver contact (1102) for the purpose of electrically contact-connecting the driver circuit (1100), wherein the driver circuit (1100) and/or the driver contact (1102) are arranged on the further printed circuit board (300).

10. Method (1400) for producing a light-emitting diode apparatus (100), wherein the method (1400) has the following steps:
providing (1402) a light-emitting diode element (102) having a front side (106) and a rear side (128), wherein the front side (106) has an emission region (108) for the purpose of emitting electromagnetic waves (110) and a diode connection contact (112) associated with the emission region (108) and the rear side (128) of the light-emitting diode element has a second diode connection contact (130);
providing (1404) a printed circuit board (104) having a through-opening (114) and a board connection contact (118); and
joining (1406) the light-emitting diode element (102) to the printed circuit board (104), wherein the front side (106) of the light-emitting diode element (102) is connected to the printed circuit board (104), and wherein the emission region (108) is arranged opposite the through-opening (114) and the diode connection contact (112) is arranged opposite the board connection contact (118) and is electrically conductively connected to the board connection contact (118); and
providing a covering unit (120) having a covering unit contact (132) and a recess (122) for the purpose of receiving the light-emitting diode element (102), wherein the covering unit (120) is composed of a further printed circuit board (300) and a frame element (302) that abuts the further printed circuit board (300), and wherein the recess (122) is formed by a passage opening (304) in the frame element (302);
arranging the covering unit contact (132) opposite the second diode connection contact (130),
producing an electrically conductive connection between the covering unit contact (132) and the second diode connection contact (130).

## Revendications

1. Dispositif à diode électroluminescente (100) possédant les caractéristiques suivantes :
un élément diode électroluminescente (102) ayant un côté avant (106) et un côté arrière (128), dans lequel le côté avant (106) possède une zone d'émission (108) destinée à l'émission d'ondes électromagnétiques (110) et un contact de raccordement de diode (112) associé à la zone d'émission (108), et le côté arrière (128) de l'élément diode électroluminescente possède un second contact de raccordement de diode (130) ;
et
une carte de circuit imprimé (104) munie d'une ouverture traversante (114) et d'un contact de raccordement de carte (118), dans lequel le côté avant (106) de l'élément diode électroluminescente (102) est relié à la carte de circuit imprimé (104), et dans lequel la zone d'émission (108) est disposée à l'opposé de l'ouverture traversante (114) et le contact de raccordement de diode (112) est disposé à l'opposé du contact de raccordement de carte (118) et est relié de manière électriquement conductrice au contact de raccordement de carte (118),
et comprenant une unité de recouvrement (120) munie d'une cavité (122) destinée à accueillir l'élément diode électroluminescente (102), dans lequel l'unité de recouvrement (120) est reliée à la carte de circuit imprimé (104) et l'élément diode électroluminescente (102) est disposé dans la cavité (122) et l'unité de recouvrement (120) possède un contact d'unité de recouvrement (132) et le contact d'unité de recouvrement (132) est disposé à l'opposé du second contact de raccordement de diode (130) et est relié de manière électriquement conductrice au second contact de raccordement de diode (130),
et dans lequel l'unité de recouvrement (120) est formée par une carte de circuit imprimé supplémentaire (300) et un élément châssis (302) qui repose sur la carte de circuit imprimé supplémentaire (300), dans lequel la cavité (122) est formée par une ouverture traversante (304) dans l'élément châssis (302).

2. Dispositif à diode électroluminescente (100) selon la revendication 1, dans lequel le côté avant (106) de l'élément diode électroluminescente (102) possède une zone d'émission supplémentaire (108) destinée à l'émission d'ondes électromagnétiques supplémentaires (110) et un contact de raccordement de diode supplémentaire (112) associé à la zone d'émission supplémentaire (108), dans lequel la carte de circuit imprimé (104) possède un contact de raccordement de carte supplémentaire (118), et dans lequel la zone d'émission supplémentaire (108) est disposée à l'opposé de l'ouverture traversante (114) et le contact de raccordement de diode supplémentaire (112) est disposé à l'opposé du contact de raccordement de carte supplémentaire (118) et est relié de manière électriquement conductrice au contact de raccordement de carte supplémentaire (118).

3. Dispositif à diode électroluminescente (100) selon l'une quelconque des revendications précédentes, dans lequel une profondeur (124) de la cavité (122) est supérieure à une épaisseur (126) de l'élément diode électroluminescente (102).

4. Dispositif à diode électroluminescente (100) selon l'une quelconque des revendications précédentes, dans lequel l'unité de recouvrement (120) est reliée au côté arrière (128) de l'élément diode électroluminescente (102) au moyen d'une couche de contact électriquement conductrice (500).

5. Dispositif à diode électroluminescente (100) selon l'une quelconque des revendications précédentes, dans lequel la carte de circuit (104) comprend un deuxième contact de raccordement de carte (140), et dans lequel l'unité de recouvrement (120) possède un contact d'unité de recouvrement supplémentaire (138) et une ligne électrique (134) reliant de manière électriquement conductrice les contacts d'unité de recouvrement (132, 138), dans lequel le contact d'unité de recouvrement supplémentaire (138) est disposé à l'opposé du second contact de raccordement de carte (140) et est relié de manière électriquement conductrice au second contact de raccordement de carte (140).

6. Dispositif à diode électroluminescente (100) selon l'une quelconque des revendications 1 à 4, dans lequel le côté avant (106) de l'élément diode électroluminescente (102) possède un second contact de raccordement de diode (130) associé à la zone d'émission (108) et la carte de circuit imprimé (104) possède un second contact de raccordement de carte (140), dans lequel le second contact de raccordement de diode (130) est disposé à l'opposé du second contact de raccordement de carte (140) et est relié de manière électriquement conductrice au second contact de raccordement de carte (140) .

7. Dispositif à diode électroluminescente (100) selon l'une quelconque des revendications précédentes, comprenant au moins un élément diode électroluminescente supplémentaire (102), dans lequel la carte de circuit imprimé (104) est munie d'au moins une ouverture traversante supplémentaire (114) et d'au moins un contact de raccordement de carte supplémentaire (118), dans lequel une zone d'émission supplémentaire (108) de l'élément diode électroluminescente supplémentaire (102) est disposée à l'opposé de l'ouverture traversante supplémentaire (114) et un contact de raccordement de diode supplémentaire (112) de l'élément diode électroluminescente supplémentaire (102) est disposé à l'opposé du contact de raccordement de carte supplémentaire (118) et est relié de manière électriquement conductrice au contact de raccordement de carte supplémentaire (118).

8. Dispositif à diode électroluminescente (100) selon l'une quelconque des revendications précédentes, comprenant un circuit d'attaque (1100) destiné à commander l'élément diode électroluminescente (102) et au moins un contact d'attaque (1102) destiné à établir un contact électrique avec le circuit d'attaque (1100), dans lequel le circuit d'attaque (1100) et/ou le contact d'attaque (1102) sont disposés sur la carte de circuit imprimé (104).

9. Dispositif à diode électroluminescente (100) selon l'une quelconque des revendications précédentes, comprenant un circuit d'attaque (1100) destiné à commander l'élément diode électroluminescente (102) et au moins un contact d'attaque (1102) destiné à établir un contact électrique avec le circuit d'attaque (1100), dans lequel le circuit d'attaque (1100) et/ou le contact d'attaque (1102) sont disposés sur la carte de circuit imprimé supplémentaire (300).

10. Procédé (1400) de fabrication d'un dispositif à diode électroluminescente (100), dans lequel le procédé (1400) comprend les étapes consistant à :
fournir (1402) un élément diode électroluminescente (102) ayant un côté avant (106) et un côté arrière (128), dans lequel le côté avant (106) possède une zone d'émission (108) destinée à l'émission d'ondes électromagnétiques (110) et un contact de raccordement de diode (112) associé à la zone d'émission (108), et le côté arrière (128) de l'élément diode électroluminescente possède un second contact de raccordement de diode (130) ;
fournir (1404) une carte de circuit imprimé (104) munie d'une ouverture traversante (114) et d'un contact de contact de raccordement de carte (118) ; et
assembler (1406) l'élément diode électroluminescente (102) avec la carte de circuit imprimé (104), dans lequel le côté avant (106) de l'élément diode électroluminescente (102) est relié à la carte de circuit imprimé (104), et dans lequel la zone d'émission (108) est disposée à l'opposé de l'ouverture traversante (114) et le contact de raccordement de diode (112) est disposé à l'opposé du contact de raccordement de carte (118) et est relié de manière électriquement conductrice au contact de raccordement de carte (118) ; et
fournir une unité de recouvrement (120) munie d'un contact d'unité de recouvrement (132) et d'une cavité (122) destinée à accueillir l'élément diode électroluminescente (102), dans lequel l'unité de recouvrement (120) est composée d'une carte de circuit supplémentaire (300) et d'un élément châssis (302) reposant sur la carte de circuit imprimé supplémentaire (300), et dans lequel la cavité (122) est formée par une ouverture traversante (304) dans l'élément châssis (302) ; disposer le contact d'unité de recouvrement (132) à l'opposé du second contact de raccordement de diode (130), établir une liaison électriquement conductrice du contact d'unité de recouvrement (132) avec le second contact de raccordement de diode (130).
